# DEMANDE DE BREVET EUROPEEN

(11) **EP 3 503 203 A1**
(43) Date de publication de la demande: **26.06.2019**
(21) Numéro de dépôt: 18215785.9
(22) Date de dépôt: 21.12.2018
(51) Int. Cl.: H01L 29/78, H01L 21/8238, H01L 21/84

(54) **RÉALISATION DE TRANSISTORS À CANAUX CONTRAINTS**

(30) Priorité: 22.12.2017 FR 1763190
(71) Demandeur: Commissariat à l'Energie Atomique et aux Energies Alternatives, 75015 Paris (FR)
(72) Inventeur: POSSEME, Nicolas, 38360 SASSENAGE (FR); LE ROYER, Cyrille, 38210 TULLINS-FURES (FR); MORAND, Yves, 38000 GRENOBLE (FR)
(74) Mandataire: Hautier, Nicolas

(57) **Abrégé**

L'invention porte notamment sur un procédé de réalisation sur une même plaque d'un premier transistor (100) surmonté au moins partiellement d'une couche contrainte en tension (190) et d'un deuxième transistor (200) surmonté au moins partiellement d'une couche contrainte en compression (290), le procédé comprend au moins les étapes suivantes:
- Fournir une plaque comprenant au moins un premier transistor (100) et un deuxième transistor (200),
- Formation d'au moins une couche contrainte sur les premier (100) et deuxième (200) transistors, la couche contrainte en tension,
- Dépôt d'une couche de protection (400a) de manière à recouvrir une première zone (191) de la couche contrainte, la première zone (191) recouvrant partiellement au moins l'un seulement parmi le premier (100) et le deuxième (200) transistors,
- Implantation (500) d'ions à base d'hydrogène à partir d'un plasma dans la deuxième zone (291), de manière à ce que la deuxième zone (291) de la couche contrainte présente une contrainte en compression.

## Description

### DOMAINE TECHNIQUE DE L'INVENTION

La présente invention concerne la réalisation de transistors de type MOS (métal-oxyde-semi-conducteur) présentant un canal contraint. Elle trouvera pour application avantageuse mais non limitative la réalisation de tels transistors sur un substrat de type FDSOI.

### ÉTAT DE LA TECHNIQUE

La réduction de la taille et l'augmentation de la rapidité des circuits microélectronique nécessitent de maîtriser avec une grande précision le courant de commande des transistors. Le courant de commande dépend notamment de la longueur de la grille, de la capacitance de la grille et de la mobilité des porteurs de charges dans le canal. Ainsi, des solutions variées ont été proposées pour réduire la longueur de la grille, augmenter la capacitance de la grille et augmenter la mobilité des porteurs de charges dans le canal du transistor.

Parmi les solutions explorées pour augmenter la mobilité des porteurs de charges, l'une consiste à introduire une contrainte mécanique dans le canal. Plus précisément, les performances des transistors de type NMOS sont améliorées en appliquant une contrainte en tension dans le canal, cette contrainte en tension permettant d'augmenter la mobilité des électrons. Les performances des transistors de type PMOS sont améliorées en appliquant une contrainte en compression dans le canal, cette contrainte permettant d'augmenter la mobilité des trous.

La figure 1 illustre une portion d'une plaque comprenant :
- un transistor 100 de type NMOS recouvert d'une couche 190 contrainte en tension, et
- un transistor 200 de type NMOS recouvert d'une couche 290 contrainte en compression.

Les figures 2a à 2f illustrent la solution conventionnelle pour réaliser ce type de structure.

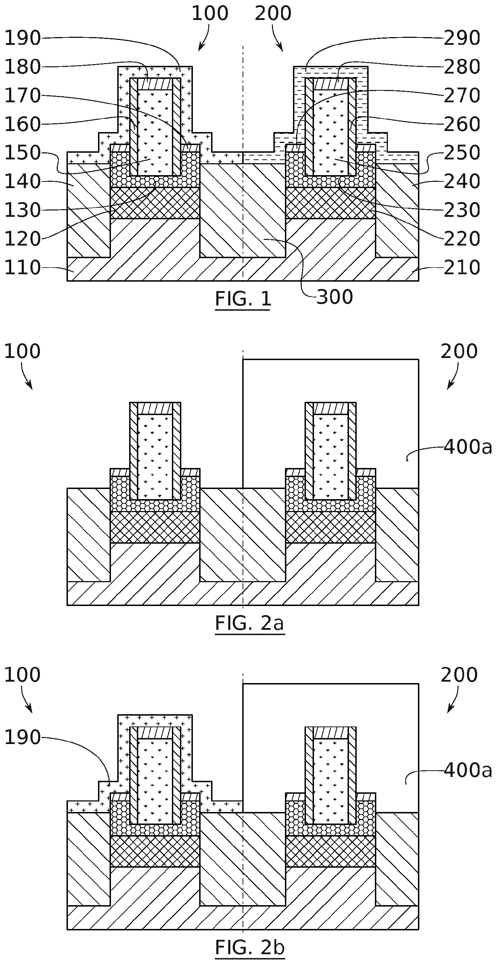

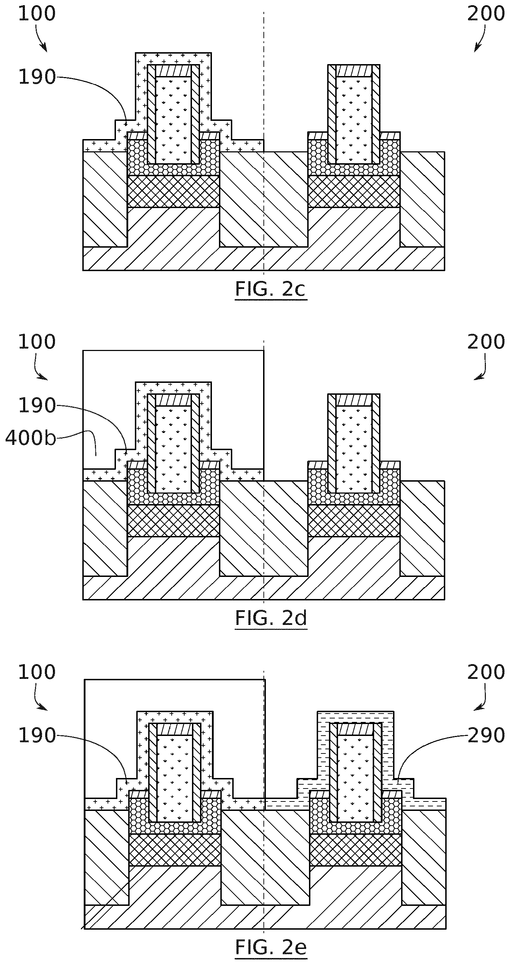

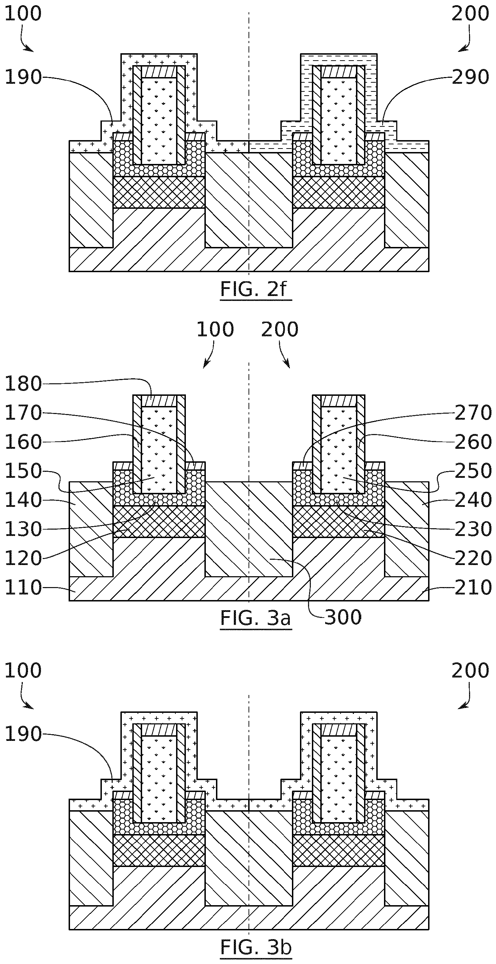

Comme illustré en figure 2a, après réalisation des transistors NMOS 100 et PMOS 200 sur une même plaque, on protège les transistors de type PMOS 200 et on laisse à découvert les transistors de type NMOS 100. Comme illustré en figure 2b, les transistors NMOS 100 sont ensuite recouverts d'une couche contrainte en tension. La protection des transistors de type PMOS est ensuite retirée comme illustré en figure 2c. On protège à leur tour les transistors de type NMOS 100 et on laisse à découvert les transistors de type PMOS 200, comme cela est illustré en figure 2d. Comme illustré en figure 2e, les transistors PMOS 200 sont ensuite recouverts d'une couche contrainte en compression. La couche de protection recouvrant les transistors NMOS 100 est ensuite retirée pour aboutir à la structure illustrée en figure 2f.

Une autre façon de procéder consiste à déposer une couche contrainte en tension pleine plaque, puis à retirer cette couche uniquement sur les transistors de type PMOS en effectuant des étapes classiques de lithogravure. Ensuite une couche contrainte en compression est déposée pleine plaque. Cette couche contrainte en compression recouvre donc les transistors PMOS et NMOS. L'étape finale consiste à retirer cette couche contrainte en compression uniquement sur les transistors de type NMOS en effectuant des étapes classiques de lithogravure.

Ce procédé de réalisation s'avère en pratique relativement long et complexe.

Il existe donc un besoin consistant à proposer une solution pour faciliter l'obtention, sur une plaque, d'une couche contrainte en tension sur un premier type de motifs et d'une couche contrainte en compression sur un autre type de motif.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, selon un mode de réalisation on prévoit un procédé de réalisation sur une même plaque d'un premier motif, de préférence un premier transistor, surmonté au moins partiellement d'une couche contrainte en tension et d'un deuxième motif, de préférence un deuxième transistor, surmonté au moins partiellement d'une couche contrainte en compression.

Les réalisations des couches contraintes en tension et en compression comprennent les étapes suivantes:
- Fournir une plaque comprenant au moins un premier motif et un deuxième motif,
- Formation d'au moins une couche contrainte recouvrant le premier motif et le deuxième motif, la couche contrainte déposée présentant une contrainte en tension,
- Dépôt d'une couche de protection de manière à recouvrir une première zone de la couche contrainte, la première zone recouvrant partiellement et de préférence entièrement l'un seulement parmi le premier et le deuxième motifs et à laisser découverte une deuxième zone de la couche contrainte, la deuxième zone recouvrant partiellement et de préférence entièrement au moins l'autre parmi le premier et le deuxième motifs,
- Modification du type de contrainte de la deuxième zone de la couche contrainte, par implantation d'ions à base d'hydrogène à partir d'un plasma dans la deuxième zone, de manière à ce que la deuxième zone de la couche contrainte présente une contrainte en compression.

Ainsi, ce procédé permet de former une couche contrainte en tension sur un premier motif est une couche contrainte en compression sur un deuxième motif. Lorsque ces motifs sont des transistors, les couches contraintes permettent de contraindre en tension et en compression le canal de chacun des transistors, améliorant de ce fait la mobilité des porteurs de charges.

Ce procédé présente un nombre d'étapes considérablement réduit par rapport aux solutions classiques mentionnées ci-dessus et illustré en figures 2a à 2f. Le procédé revendiqué permet donc d'augmenter la fiabilité et de réduire les coûts de fabrication.

Selon un mode de réalisation avantageux, le premier et le deuxième motifs sont des transistors qui présentent des caractéristiques différentes. Par exemple ils peuvent présenter des dopages différents. Ainsi, selon un exemple, le premier motif et le deuxième motif sont des transistors de préférence respectivement de type NMOS et PMOS.

Alternativement ou en combinaison, le premier transistor et le deuxième transistor peuvent présenter des épaisseurs différentes d'oxyde de grille.

Alternativement ou en combinaison, le premier transistor et le deuxième transistor peuvent présenter des épaisseurs différentes de canal.

Dans le cadre du développement de la présente invention, il a été envisagé de déposer une couche contrainte en tension recouvrant à la fois les transistors de type NMOS est de type PMOS, puis de protéger les transistors de type NMOS, puis d'appliquer une étape de traitement additionnel pour inverser la contrainte dans la couche recouvrant les transistors PMOS, cette étape de traitement additionnel consistant essentiellement en un traitement par ultraviolet, par laser ou par faisceau d'électrons (e-Beam).

L'application d'un traitement par ultraviolet avec une puissance comprise entre 300 W/m2 et 2000W/m2, combinée à un traitement thermique portant la température du substrat à une température de plusieurs dizaines voire centaines de degrés semble pouvoir permettre de passer d'une contrainte en tension à une contrainte en compression. Néanmoins, ce type de traitement nécessite une durée longue, typiquement de plusieurs minutes à plusieurs dizaines de minutes, ce qui n'est pas compatible avec les contraintes de productivité industrielle.

Par ailleurs, des procédés qui feraient intervenir une implantation dans la couche contrainte d'ions lourds présenteraient plusieurs inconvénients. En particulier, cette implantation risquerait d'altérer la couche sous-jacente à la couche contrainte lorsque cette dernière est relativement peu épaisse. Les performances du transistor s'en trouveraient immédiatement dégradées. Par ailleurs, l'implantation d'ions lourds aurait pour conséquence d'altérer la géométrie et les dimensions des blocs de protection recouvrant les transistors de type NMOS. Typiquement lorsque ces blocs de protection sont en résine, l'implantation d'ions lourds conduirait un certain fluage de ces blocs de protection. Cela dégraderait la qualité de l'interface entre la couche contrainte protégée et la contrainte non protégée. Il en résulterait une faible maîtrise de l'interface entre la couche contrainte en tension et la couche contrainte en compression.

Il s'est donc avéré que ce type de solutions présentes de nombreux inconvénients.

Le procédé revendiqué réduit voire supprime ces inconvénients.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La FIGURE 1 est une structure comprenant un transistor de type NMOS recouvert d'une couche contrainte en tension et un transistor de type PMOS recouvert d'une couche contrainte en compression.
La FIGURE 2, comprenant les figures 2a à 2f, illustre différentes étapes d'un procédé de l'état de la technique.

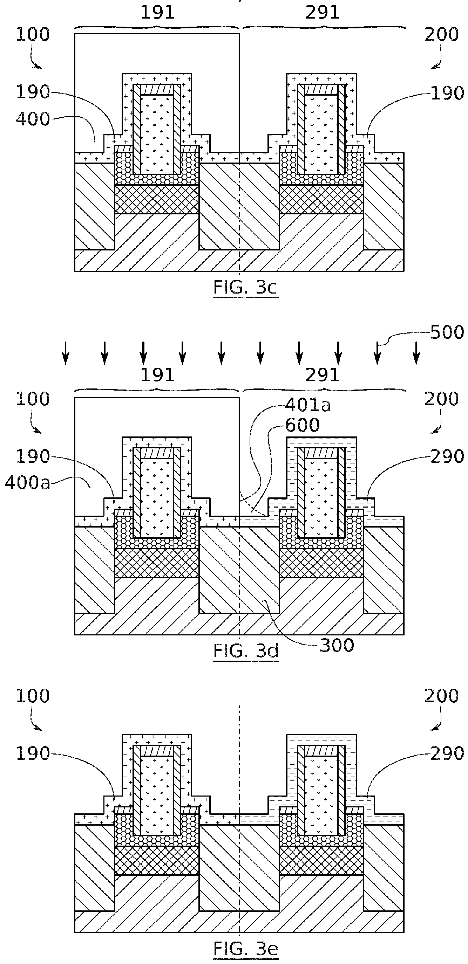

La FIGURE 3, comprenant les figures 3a à 3e, illustre différentes étapes d'un procédé selon un exemple non limitatif de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
Selon un exemple, la couche contrainte en tension et la couche contrainte en compression sont de préférence des couches à base de nitrure et de préférence faite de nitrure. De préférence ces couches sont des couches de nitrure de silicium SixNy, x et y étant des entiers. De préférence il s'agit de SiN, SiN₃, Si₂N₄.

Selon un exemple, la première zone recouvre entièrement le premier motif formant un transistor et la deuxième zone recouvre entièrement le deuxième motif formant un transistor.

Toutes les caractéristiques qui suivent peuvent être généralisées au cas où un transistor est un motif.

Selon un exemple, une tranchée d'isolation électrique sépare le premier transistor et le deuxième transistor. La première et la deuxième zones s'étendent chacune jusqu'à la tranchée d'isolation. De préférence, une interface définie par la première et la deuxième zones est au moins en partie située au droit de la tranchée d'isolation. Cela signifie que le flanc de la couche de protection (qui définit la délimitation entre couche contrainte en tension et couche contrainte en compression) est situé sur la tranchée d'isolation.

Selon un exemple, le dépôt de la couche de protection est effectué de manière à recouvrir une partie au moins du premier transistor de type NMOS, et de préférence l'intégralité du premier transistor de type NMOS, et à laisser entièrement découvert le deuxième transistor de type PMOS.

Selon un exemple, le premier transistor et la couche contrainte sont conformées de manière à contraindre en tension au moins un canal du premier transistor.

Selon un exemple, le deuxième transistor et la couche contrainte sont conformées de manière à contraindre en compression au moins un canal du deuxième transistor.

Selon un exemple, le plasma est formé à partir d'un mélange comprenant du H2.

Selon un exemple, les paramètres du plasma, en particulier la nature et l'énergie des ions, sont régulés de manière à ce que l'implantation d'ions réduise l'épaisseur de la couche contrainte dans la deuxième zone. Cela permet par exemple de mieux contrôler l'épaisseur de la couche contrainte de la deuxième zone.

Selon un exemple, le plasma est formé à partir d'un mélange comprenant au moins l'un des gaz suivants : HBr, NH3.
Un avantage de cette chimie est que durant la modification de la couche contrainte découverte, l'épaisseur de cette dernière peut être réduite par le bombardement des espèces plus lourdes que l'hydrogène (par exemple les espèces Br et N) présentes dans le plasma.

Cela permet d'ajuster l'épaisseur de la couche contrainte.

Ce meilleur contrôle de l'épaisseur de la couche contrainte procure par exemple pour avantage que l'épaisseur des couches contraintes surmontant tous les sources et drains, quel que soient les transistors, ait la même épaisseur à la surface de la plaque. Lors de la gravure de cette couche pour ouvrir les contacts pour effectuer les reprises électriques, les sources et drains seront donc atteints au même moment.

Par ailleurs, cela permet d'éviter de possibles court-circuits entre les zones actives de transistors adjacents.

Selon un exemple, le plasma est formé à partir d'un mélange comprenant au moins un gaz de type CxHy, x et y étant des entiers et de préférence un autre gaz par exemple l'hélium (He) et/ou l'argon (Ar).
Un avantage de cette chimie est que durant la modification de la couche contrainte découverte, l'épaisseur de cette dernière peut être réduite par le bombardement des espèces plus lourdes que l'hydrogène (par exemple les espèces He et Ar) présentes dans le plasma.
Cela permet d'ajuster l'épaisseur de la couche contrainte, avec par exemple les avantages mentionnés ci-dessus.
Par ailleurs, cette chimie permet de réduire la consommation de la couche de protection en particulier lorsque cette dernière est carbonée. Tel est le cas lorsque la couche de protection est une résine photo ou thermosensible.
Dans ce cas, des atomes de carbone, issus de la dissociation des molécules de CxHy, se déposent sur la résine ce qui la protège du bombardement des autres ions (argon ou hélium par exemple) lors de l'implantation plasma. La résine conserve ainsi durant toute l'implantation ses dimensions et sa géométrie.
Ce mode de réalisation permet ainsi d'avoir un contrôle dimensionnel particulièrement élevé à l'interface entre le premier et le deuxième transistors.

Selon un exemple, la formation de la couche contrainte est effectuée de manière à ce que la couche contrainte présente une épaisseur comprise entre 2 et 50 nm (10⁻⁹ mètres), de préférence entre 5 et 40nm.

Avantageusement, l'étape de modification du type de contrainte de la deuxième zone de la couche contrainte est effectuée une température inférieure à 150° Celsius. Plus précisément, l'implantation est réalisée à une température T ≤ 150°C, de préférence T ≤ 130°C et de préférence T ≤ 100°C. De préférence, T est comprise entre 10°C et 100°C. De manière particulièrement avantageuse, le procédé ne se base pas sur l'élévation de température de la couche contrainte pour la relaxer.

Selon un exemple, la formation de la couche contrainte comprend un dépôt, de préférence conforme.

Selon un exemple, le dépôt conforme est effectué par l'un des dépôts suivants : dépôt chimique en phase vapeur assisté par plasma (PECVD), dépôt chimique en phase vapeur assisté à basse pression (LPCVD), dépôt thermique rapide chimique en phase vapeur (RTCVD), dépôt physique en phase vapeur (PVD).

Selon un exemple, les paramètres de l'implantation, en particulier l'énergie des ions à base d'hydrogène, sont choisis de manière à modifier par implantation toute l'épaisseur de la deuxième zone de la couche contrainte.

Selon un exemple, les paramètres de l'implantation, en particulier l'énergie des ions à base d'hydrogène, sont choisis de manière à modifier par implantation la couche contrainte découverte, de manière continue, depuis la surface de la couche contrainte et jusqu'à une profondeur de l'ordre de 40 nm (10⁻⁹ mètres).

Selon un exemple, l'implantation est réalisée à une température ≤ 150°C, de préférence ≤ 130°C.

Selon un exemple, le procédé comprend, après l'étape de modification, une étape de retrait de la couche de protection.

Selon un exemple, le procédé comprend une pluralité de séquences, chaque séquence étant appliquée sur lesdits premiers et deuxièmes transistors, chaque séquence comprenant successivement au moins : ladite étape de dépôt d'une couche contrainte, ladite étape de dépôt d'une couche de protection et ladite étape de modification. Ainsi la couche contrainte est formée par des dépôts successifs. Ces dépôts s'empilent les uns sur les autres. Chaque séquence est appliquée sur une même zone de la plaque.

Ce mode de réalisation permet d'augmenter encore la précision de la modification de la couche contrainte, ce qui permet in fine d'améliorer la précision de la contrainte imposée dans le canal.

Selon un exemple, à chaque séquence, ladite étape de dépôt d'une couche contrainte est configurée de manière à ce que l'épaisseur de la couche contrainte déposée soit inférieure à 30 nm de préférence inférieure à 20 nm et de préférence comprise entre 5 nm et 15 nm

Selon un exemple, les premier et deuxième transistors présentent chacun un canal formé dans une couche semi-conductrice, la couche semi-conductrice surmontant une couche diélectrique et un substrat de support. La couche semi-conductrice, la couche diélectrique et le substrat de support forment un substrat de type semi-conducteur sur isolant.
Selon un exemple, les premier et deuxième transistors sont formés sur un substrat de type FDSOI.
Selon un exemple, les premier et deuxième transistors sont formés sur un substrat de type PDSOI.
Selon un exemple, les ions à base d'hydrogène (H) sont de préférence pris parmi les ions suivants: H, H⁺, H₂⁺, H₃⁺.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un film, une couche, « à base » d'un matériau A, un substrat, un film, une couche comprenant ce matériau A uniquement ou ce matériau A et éventuellement d'autres matériaux, par exemple des éléments dopants

Le mot « diélectrique » qualifie un matériau dont la conductivité électrique est suffisamment faible dans l'application donnée pour servir d'isolant.

Dans le cadre de la présente invention, on qualifie de résine un matériau organique ou organo-minéral pouvant être mis en forme par une exposition à un faisceau d'électrons, de photons ou de rayons X ou mécaniquement.

On peut citer à titre d'exemple des résines classiquement employées en microélectronique, des résines à base de polystyrène (PS), de méthacrylate (par exemple le Polymethyl methacrylate PMMA), d'Hydrosilsesquioxane (HSQ), de polyhydroxystyrène (PHS) etc. L'intérêt d'utiliser une résine est qu'il est facile d'en déposer une épaisseur importante, de plusieurs centaines de nanomètres à plusieurs microns.

Il est précisé que dans le cadre de la présente invention, l'épaisseur d'une couche ou du substrat se mesure selon une direction perpendiculaire à la surface selon laquelle cette couche ou ce substrat présente son extension maximale. Sur les figures, l'épaisseur est prise selon la verticale.

Lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures.

Dans la présente demande de brevet, un dopage noté P englobe tous les dopages par porteurs de charges positives (trous) quelle que soit la teneur du dopage. Ainsi, un dopage P comprend les teneurs en dopage P+ et les teneurs en dopage P inférieures au dopage de type P+. De même, un dopage noté N englobe tous les dopages par porteurs de charges négatives quelle que soit la teneur du dopage. Ainsi, un dopage N comprend les teneurs en dopage N+ et les teneurs en dopage N inférieures au dopage de type N+.

De manière conventionnelle, un dopage noté P+ signifie qu'il s'agit d'un dopage de type P (dopage par des charges positives) et dont la teneur en espèce dopante est supérieure ou égale à 1 atome de l'espèce dopante pour moins de 500 atomes du semi-conducteur et de préférence pour moins de 10 à 100 atomes du matériau formant la couche semi-conductrice. De même, un dopage N+ signifie qu'il s'agit d'un dopage de type N (dopage par des charges négatives) et dont la teneur en espèce dopante est supérieure ou égale à 1 atome de l'espèce dopante pour moins de 500 atomes du semi-conducteur et de préférence pour moins de 10 à 100 atomes du matériau formant la couche semi-conductrice.

La figure 3a illustre un exemple non limitatif de structure à partir de laquelle le procédé revendiqué peut être mis en oeuvre.

Cette structure comprend un premier motif, dans cet exemple un premier transistor 100 et un deuxième motif, dans cet exemple un deuxième transistor 200. Dans cet exemple non limitatif, le premier transistor 100 est de type NMOS et le deuxième transistor 200 et de type PMOS.

Chaque transistor 100, 200 comprend par exemple :
- une couche active 130, 230 formant un canal. Ce canal est fait d'un matériau semi-conducteur. Il s'agit typiquement d'un matériau à base de silicium tel que le silicium -(Si) ou le silicium-germanium (SiGe) ;
- un empilement de grille comprenant notamment une grille 150, 250 habituellement en silicium dopé ou en métal, une couche métallique et une couche isolante électriquement dite oxyde de grille située entre la couche active et la grille en silicium polycristallin. L'empilement de grille peut également comprendre une couche diélectrique dite « high-k », c'est-à-dire faite d'un matériau à haute permittivité. Lorsqu'elle est présente, cette couche diélectrique est située entre l'oxyde de grille et la grille métallique.
   L'empilement de grille comprend également une reprise de contact 180, 280. Cette reprise de contact 180 est située sur le sommet de l'empilement de grille afin d'en permettre la connexion électrique avec d'autres parties du circuit. La reprise de contact est formée dans un matériau conducteur. Typiquement, elle est réalisée par siliciuration. Sur la figure 3a, pour des raisons de clarté et de concision seule la grille 150, 250 et la reprise de contact 180, 280 sont illustrées.
- de préférence des espaceurs qui recouvrent des flancs de l'empilement de grille. Typiquement, ces espaceurs sont formés dans des matériaux présentant une faible constante diélectrique. Ils peuvent être poreux ou non. Ils sont par exemple formés dans l'un des matériaux suivants : SiCO, SiC, SiCN, SiOCN ou SiCBN, ou un nitrure de silicium (SixNy, x et y étant des entiers).
- des zones de source et drain formées par la couche active 130, 230 (ou par épitaxie à partir de cette dernière) et disposées de part et d'autre du canal.
- Des reprises de contact 170,270 pour la connexion électrique des zones de source et drain. Ces reprises de contact 170, 270 sont formées de matériau conducteur et sont de préférence formées par siliciuration.

La couche active 130, 230 de chaque transistor 100, 200 surmonte une couche isolante 120 électriquement. De préférence, l'ensemble est supporté par un substrat de support 110.

De préférence, le substrat de support 110, la couche isolante 120 et la couche active 130 forment un substrat élaboré de type silicium sur isolant (SOI) ou plus généralement semi-conducteur sur isolant. La couche isolante 120 est alors qualifiée de couche d'oxyde enterré (BOX). La couche active 130 est de préférence très fine.

Ces substrats élaborés 100 sont qualifiés de FDSOI (fully depleted silicon on insulator signifiant silicium-sur-isolant totalement déserté ou plus généralement semi-conducteur-sur-isolant totalement déserté) ou PDSOI (partially depleted silicon on insulator signifiant silicium-sur-isolant partiellement déserté ou plus généralement semi-conducteur-sur-isolant partiellement déserté) en fonction principalement de l'épaisseur de la couche active 130, 230 semi-conductrice.

La structure illustrée en figure 3a montre également la présence de tranchées d'isolation 140, 240 traversant toute la couche active 130, 230 pour isoler deux transistors 100, 200. Ces tranchées d'isolation 140, 300, 240 s'étendent à travers toute l'épaisseur de la couche active 130, 230 et jusque dans le substrat de support 110. Ces tranchées d'isolation 140, 300, 240 sont typiquement réalisées en oxyde, typiquement en SiO2.

Les figures 3b à 3e illustrent les étapes principales de formation des couches contraintes en tension et en compression sur les transistors 100 et 200. Naturellement, ce procédé peut être appliqué à des structures bien différentes de celles illustrées en figure 3a.

Comme illustré en figure 3b, on procède à la formation d'une couche contrainte 190. Cette couche contrainte 190 est de préférence contrainte en tension. Il peut s'agir d'une couche de type CESL, acronyme de contact etch stop layer (couche d'arrêt de gravure). Typiquement, la couche contrainte 190 est une couche de nitrure. Il s'agit par exemple d'une couche de nitrure de silicium (SixNy x et y étant des entiers). De préférence, la couche contrainte 190 est en SiN.

Cette couche contrainte 190 présente une épaisseur de quelques nanomètres à quelques dizaines de nanomètres. Typiquement son épaisseur est comprise entre 5 et 40 nm (10⁻⁹ mètres), par exemple 20 nm.

La formation de la couche contrainte comprend un dépôt conforme. Il est par exemple effectué par l'une des techniques suivantes de dépôt : dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt thermique CVD rapide (RTCVD, acronyme de rapid thermal CVD), dépôt physique en phase vapeur (PVD, acronyme de physical vapor déposition), dépôt par couche atomique (ALD, acronyme de atomic layer déposition). D'autres types de dépôts peuvent être envisagés.

De préférence, la couche contrainte 190 est déposée à une température supérieure à 400 °C et de préférence supérieure à 500 °C. Selon un mode de réalisation, cette température correspond à la température à laquelle le substrat de support 110 est maintenu lors du dépôt.

Avantageusement, cette couche contrainte 190 recouvre en partie au moins le premier transistor 100 est en partie au moins le deuxième transistor 200. De préférence, et comme cela est illustré sur la figure 3b, l'intégralité de ces transistors est recouverte par la couche contrainte 190. En effet, on effectue de préférence un dépôt pleine plaque.

L'étape suivante, illustrée en figure 3c vise à masquer les transistors de l'un des deux types, les transistors NMOS 100 dans cet exemple. À cet effet, on peut par exemple réaliser une couche de protection 400a sur une première zone 191 de la couche contrainte 190, la première zone 191 recouvrant une partie au moins du transistor NMOS 100. Une deuxième zone 291 de la couche contrainte 190 n'est pas recouverte par la couche de protection 400a. Cette deuxième zone 291 de la couche contrainte 190 recouvre, en partie au moins et de préférence entièrement, le transistor PMOS 200.

Dans la pratique, pour chaque transistor, les zones où les couches contraintes contribuent à contraindre le canal du transistor sont situées autour de la grille du transistor (sur le sommet de la grille et sur les flancs de la grille) ainsi que sur les zones de source et drain proches de la grille.

Dans la pratique, les transistors d'un même type sont de préférence alignés dans le plan des figures. On dépose donc une couche de protection 400a sur un ensemble de transistors adjacents du même type. La contrainte appliquée sur les canaux de ces transistors découlera des mêmes étapes de procédé. Deux transistors de type différent sont adjacents dans un plan perpendiculaire à celui des figures. Néanmoins, la représentation illustrée sur les figures permet d'illustrer et d'expliquer l'invention de manière plus claire et concise.

De préférence, cette couche de protection 400a est en résine. Elle est par exemple réalisée en déposant pleine plaque une couche de résine photosensible, puis en définissant par lithographie un bloc de protection.

De préférence, la couche de protection 400a s'étend jusqu'à une tranchée d'isolation 300 séparant les transistors 100 et 200. Typiquement, le bloc de protection recouvrant le transistor 100 présente un flanc 401a situé au droit de la tranchée d'isolation 300.

L'étape suivante consiste à modifier la couche contrainte 190 qui n'est pas masquée (c'est-à-dire la deuxième zone 291 de la couche contrainte 190) de manière à inverser la nature de la contrainte dans cette zone 291 de la couche contrainte 190. En revanche, au cours de cette étape, la contrainte de la première zone 191 de la couche contrainte 190 ne doit pas être inversée.

À cet effet, on implante, à partir d'un plasma, des ions légers dans la deuxième zone 291 de la couche contrainte. Les paramètres d'implantation 500, en particulier l'énergie communiquée aux ions, la durée et la dose d'implantation sont prévus de sorte à inverser la nature de la contrainte dans les portions modifiées par implantation (c'est-à-dire la deuxième zone 291 de la couche contrainte).

De préférence, cette implantation 500 est effectuée pleine plaque. La couche de protection 400a est configurée, en particulier son épaisseur et sa nature, de manière à ce que l'implantation 500 ne modifie pas la couche contrainte 190 dans la première zone 191.

Les ions légers implantés sont des ions à base d'hydrogène. Les ions à base d'hydrogène (H) sont de préférence pris parmi les ions suivants: H, H⁺, H₂⁺, H₃⁺. Ces ions, dits « légers », ont pour avantage de pénétrer dans la couche contrainte 190 sans la pulvériser, voir sans la dégrader.

L'implantation 500 par plasma a pour avantage de permettre une implantation 500 de manière continue dans un volume s'étendant dès la surface de la couche implantée 190.

Avantageusement, l'implantation 500 est effectuée de manière à ce que les ions implantés soient répartis de manière ininterrompue depuis la surface de la couche contrainte 190 et jusqu'à une profondeur souhaitée. Cette répartition ne présente pas de discontinuité. Il n'y a donc pas de couches où les espèces implantées sont absentes entre la surface de la couche 190 et la profondeur maximale d'implantation.

Cette répartition peut être homogène. Cela conduit à une contrainte plus homogène au sein de la couche 190 que ce que l'on aurait obtenu avec des implanteurs classiques. Ainsi, on contrôle mieux la contrainte au sein du canal du transistor 200.

Alternativement, cette répartition peut être non homogène. Typiquement, cette répartition va alors décroissant depuis la surface de la couche 190 et jusqu'à ladite profondeur.

En outre, l'utilisation d'un plasma permet une implantation 500 à des profondeurs plus faibles que les profondeurs minimales que l'on peut obtenir avec des implanteurs. Ainsi, une implantation 500 par plasma permet d'implanter efficacement et de manière relativement homogène ou tout au moins de manière continue des épaisseurs fines. Ainsi, on évite d'implanter et donc d'altérer les couches qui se situent sous la couche contrainte 190, même dans les cas où cette couche 190 est très fine.

L'implantation 500 d'un plasma permet typiquement d'implanter des épaisseurs s'étendant depuis la surface de la couche implantée et sur une profondeur allant de 0 nm à 100 nm. Les implanteurs classiques, permettent une implantation 500 dans un volume compris entre 30 nm et plusieurs centaines de nanomètres. En revanche, les implanteurs classiques ne permettent pas d'implanter les espèces entre la surface de la couche à implanter et une profondeur de 30 nm.

L'utilisation d'un plasma pour modifier la couche contrainte 190 est donc particulièrement avantageuse lorsque cette dernière présente une épaisseur faible, typiquement comprise entre 1 et 50 nm et plus généralement entre 1 et 100 nm.

L'étape de modification réalisée à partir d'un plasma modifie la couche 700 à base de nitrure de silicium de manière continue depuis la surface de cette couche et sur une épaisseur comprise entre 1 nm et 30nm et de préférence entre 1 nm et 10 nm.

Par ailleurs, l'utilisation d'un plasma permet d'implanter les ions avec une forte anisotropie et avec une bonne précision de la direction d'implantation. Cela contribue à améliorer le contrôle des zones implantées, et donc in fine la compression dans le canal du transistor 200 ainsi que l'interface entre la zone 191 contrainte en tension et la zone contrainte en compression 291.

De préférence, l'implantation 500 est configurée de manière à faire passer la couche contrainte 190 d'une contrainte en tension à une contrainte en compression. Pour cela, l'homme du métier régulera en particulier les paramètres suivants :
- L'épaisseur de la couche contrainte à modifier. L'épaisseur modifiée à chaque étape d'implantation dépendra de l'épaisseur de la couche contrainte. Typiquement, cette épaisseur modifiée est comprise entre 1 nm et 100 nm et de préférence entre 1 et 6 nm. Plus généralement l'épaisseur modifiée sera de quelques dizaines de nanomètres typiquement elle sera comprise entre 10 nm et 60 nm, de préférence entre 25 nm et 45 nm et de préférence de l'ordre de 30 nm.
- La puissance de la source.
- La nature du gaz dont seront issus les ions hydrogène implantés. On pourra par exemple utiliser l'un des gaz suivants : H2, HBr, NH3, CxHy (x et y étant des entiers). Les avantages associés à chacun de ces gaz seront détaillés ci-dessous.
- Le débit du gaz dans le réacteur.
- La tension de polarisation, habituellement désignée bias.
- La pression dans le réacteur.
- La température.
- La durée d'implantation.

L'homme du métier sait ajuster chacun de ces paramètres afin d'inverser la nature de la contrainte dans la couche contrainte 190. Notamment, la durée de l'implantation impacte la dose dans la couche contrainte 190. Une durée d'implantation plus importante conduit à une contrainte plus forte en compression.

Selon un mode de réalisation, l'implantation d'ions à base d'hydrogène est réalisée dans un réacteur plasma permettant de contrôler l'énergie des ions. Il peut par exemple s'agir d'un réacteur plasma à couplage inductif (ICP), d'un réacteur plasma à couplage capacitif (CCP) ou encore d'un plasma par immersion.

De manière avantageuse, la température de la plaque lors de l'implantation est inférieure à 150°C.

Comme indiqué ci-dessus, les ions à base d'hydrogène proviennent par exemple d'un plasma de H2. Ce gaz permet d'éviter les risques de pulvérisation de la couche contrainte 190.

Alternativement, et comme indiqué ci-dessus, les ions à base d'hydrogène peuvent provenir des gaz suivants NH3 et HBr. L'utilisation de ces gaz a pour avantage d'endommager la couche contrainte 190 lors de l'implantation. Cela permet d'ajuster l'épaisseur de cette couche 190 dans la deuxième zone 291 c'est-à-dire, dans ce mode de réalisation, de modifier l'épaisseur de la couche contrainte recouvrant les transistors de type PMOS 200. En modifiant l'épaisseur de cette couche, on peut ainsi ajuster la contrainte imposée au canal du transistor 200. De manière plus générale, on pourra réguler les paramètres du plasma, en particulier la nature des ions et leur énergie, afin d'atteindre ce résultat.

Alternativement, et comme indiqué ci-dessus, les ions à base d'hydrogène peuvent provenir d'une chimie de type CxHy. Il s'agit par exemple d'un plasma formé à partir des gaz suivants : CH4 ou CH4 et He. Ce type de gaz présente les mêmes avantages que les gaz NH3 et HBr mentionnés ci-dessus. En outre, ce type de chimie permet de limiter la consommation de résine de la couche de protection 400 lors de l'implantation 500. En effet, lorsque la couche de protection 400a comprend du carbone, comme c'est le cas lorsque la couche de protection 400a est une résine photo ou thermosensible, des atomes de carbone, issus de la dissociation des molécules de CxHy, se déposent sur la résine ce qui la protège du bombardement des autres ions du plasma tel que les ions argon ou hélium par exemple . La résine conserve ainsi durant toute l'implantation ses dimensions et sa géométrie.

Ce mode de réalisation permet ainsi d'avoir un contrôle dimensionnel particulièrement élevé de la couche de protection carbonée. In fine cela permet d'améliorer le contrôle dimensionnel de la zone à implanter et de l'interface entre le premier et le deuxième transistors. Page 15 ligne 17

Ce type de chimie permet ainsi de conserver la géométrie et les dimensions de la couche de protection 400a. Il en résulte que les frontières entre les zones contraintes en tension 191 et les zones contraintes en compression 291 sont mieux maîtrisées.

Avantageusement, l'implantation par plasma ne génère pas de fluage de la couche de protection 400a ou limite le fluage. À l'inverse, si pour l'étape de modification de la nature de la contrainte dans la zone découverte, il avait été fait recours à une exposition à un rayonnement ultraviolet, ce qui aurait nécessité un temps de procédé relativement important, on aurait alors constaté un fluage significatif de la couche de protection 400a en résine. Un tel fluage est représenté de manière schématique par la référence 600 sur la figure 3d. Un tel fluage dégrade considérablement le contrôle dimensionnel de la zone implantée. L'interface entre zones contraintes en tension et zones contraintes en compression n'est alors plus maîtrisée avec précision, ce qui conduit à une dégradation des performances des transistors. En limitant le fluage, le procédé proposé permet par conséquent d'améliorer la précision de l'interface entre zones contraintes en tension et zones contraintes en compression, ce qui conduit à une amélioration des performances des transistors.

L'étape suivante, illustrée en figure 3e consiste à retirer la couche de protection 400a. Cette étape est connue de l'homme du métier. Elle peut par exemple être effectuée à l'aide d'un plasma d'oxygène.

On obtient ainsi, sur une même plaque, des transistors 100 recouverts d'une couche contrainte en tension 190 et d'autres transistors 200 recouverts d'une couche contrainte en compression 290.

Pour finaliser la structure, on peut ensuite effectuer des étapes classiques comme par exemple l'ouverture des couches contraintes 190, 290 au niveau des reprises de contacts 170, 180, 270, 280 pour connecter électriquement la grille, les sources et le drain.

Selon un mode de réalisation, la couche contrainte est formée par un unique dépôt. La modification de la deuxième zone 291 de la couche contrainte est obtenue par une unique étape de modification par implantation plasma.

Selon un mode de réalisation alternatif, la couche contrainte est formée par une pluralité de dépôts successifs. Après chaque dépôt, ou au moins après certains d'entre eux, on effectue une étape de modification par implantation. Ce mode de réalisation permet d'avoir un meilleur control de la modification de la couche contrainte. Par conséquent, on contrôle plus précisément l'inversion de contrainte et l'amplitude de la contrainte dans la deuxième zone 291. Ce mode de réalisation permet également de former des couches contraintes épaisses, permettant de ce fait de réguler précisément la tension dans le canal de chacun des transistors. Par exemple, à chaque séquence, on peut déposer une couche d'environ 10 nm puis la modifier au niveau de la deuxième zone 291.

Les conditions ci-dessous donnent des exemples non limitatifs pour modifier la couche contrainte sur une épaisseur comprise entre 1 et quelque dizaines de nanomètres nm, typiquement entre 1 et 60nm.

Ces modifications sont effectuées dans tout type d'équipement permettant d'implanter par plasma des ions hydrogène tout en contrôlant l'énergie des ions implantés. On pourra ainsi recourir à des réacteurs de type ICP ou CCP.

Deux exemples vont être donnés ci-dessous en fonction de la chimie du plasma utilisé.

### • Modification à l'aide d'une chimie de type H2, HBr ou NH3

- puissance de la source: 500 à 2000 watts.
- nature du gaz dont seront issus les ions hydrogène implantés : H2, HBr, NH3 ou une combinaison de ces gaz.
- débit du gaz : 10 et 500 sccm
- tension de polarisation (bias) : 100 V à 800 V.
- pression : 5 à 200 milli Torr
- température : 10°C à 100°C.
- durée : quelques secondes à quelques minutes.

On notera que la fenêtre du procédé est contrainte par les étapes qui seront effectuées par la suite. En particulier, les conditions mentionnées ci-dessus dépendent de la température qui sera appliquée lors des étapes ultérieures.

Les conditions ci-dessous donnent un exemple non limitatif pour inverser la contrainte d'une couche de nitrure de silicium (SiN), déposée par LPCVD et présentant une épaisseur de 20 nm. Plus précisément, les paramètres ci-dessous permettent de passer d'une contrainte en tension à une contrainte en compression.

**Tableau 1 :**

| | |
|---|---|
| Épaisseur modifiée : | 20 nm |
| Chimie : | H2: 250 sccm |
| Puissance de la source 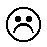 | 500 Watts (Plasma ICP) |
| Tension de polarisation (bias) : | Voir Tableau 2 ci-dessous |
| Pression : | 80 milli Torr |
| Température : | 20-100°C |
| Temps : | 60 secondes |

Le tableau 2 ci-dessous donne les différentes contraintes que l'on obtient, après modification par implantation conformément aux conditions du Tableau 1, en fonction de :
- la courbure initiale de la plaque. La plaque présente typiquement une diagonale ou un diamètre de 300 mm.
- la tension de polarisation (bias).

**Tableau 2 :**

| Tension de polarisation (bias) Voltage (V) | Courbure initiale | Courbure finale | Nature de la contrainte |
|---|---|---|---|
| 100V | 28,415 | 11,445 | tension |
| | 29,874 | 12,355 | |
| | 26,745 | 9,393 | |
| | 24,734 | 7,5331 | |
| 250V | 34,998 | 7,9724 | |
| | 36,482 | 8,6194 | |
| | 31,49 | 3,8845 | |
| | 34,351 | 6,7323 | |
| 400V | 28,206 | -5,84 | compression |
| | 32,206 | -2,6227 | |
| | 26,922 | -7,2638 | |
| | 32,23 | -2,3379 | |

On observe ainsi qu'à partir d'une tension de polarisation de 400 V, la contrainte en tension de la couche de nitrure de silicium est convertie, par implantation, en une contrainte en compression.

### • Modification à l'aide d'une chimie de type CxHy, x et y étant des entiers

- puissance de la source: 0 à 2000 watts.
- nature du gaz dont seront issus les ions hydrogène implantés : He et CH4 ou H2, CH4 et Ar
- débit des gaz :
   ∘ H2 : 50 à 500 sccm
   ∘ He : 50 à 500 sccm
   ∘ Ar : 100 à 1000 sccm
   ∘ CH4 : 5 à 15 sccm
- tension de polarisation (bias) : 20 V à 500 V.
- pression : 5 à 200 milli Torr
- température : 10 °C à 100 °C.
- durée : quelques secondes à quelques minutes.

On notera que la fenêtre du procédé est large. Les conditions dépendent des applications ainsi que de l'épaisseur du film de nitrure à modifier et à graver. En effet, le bombardement d'ions plus lourds que les ions hydrogène (typiquement des ions hélium ou argon) conduit à graver la couche nitrure.

Les conditions ci-dessous donnent un exemple non limitatif pour inverser (passage d'une contrainte en tension et une contrainte en compression) la contrainte d'une couche de nitrure de silicium (SiN) présentant une épaisseur de 17 nm.

**Tableau 3 :**

| | |
|---|---|
| Épaisseur modifiée : | 17 nm |
| Chimie : | He : 250 sccm |
| | CH4 :10 sccm |
| Puissance de la source : | 250 W (plasma ICP) |
| Puissance de la polarisation (bias) : | 250 V |
| Pression : | 10 milli Torr |
| Température : | 20-100°C |
| Temps: | 60 secondes |

Ainsi, au vu de la description qui précède, il apparaît clairement que le procédé proposé permet de réduire le cout et de rendre plus fiable la réalisation de couches contraintes en tension et en compression sur des motifs d'une plaque, typiquement sur des transistors présentant des caractéristiques différentes, par exemple des transistors NMOS et PMOS.

L'invention n'est pas limitée aux modes de réalisations précédemment décrits et s'étend à tous les modes de réalisation couverts par les revendications.

## Revendications

1. Procédé de réalisation sur une même plaque d'un premier transistor (100) surmonté au moins partiellement d'une couche contrainte en tension (190) et d'un deuxième transistor (200) surmonté au moins partiellement d'une couche contrainte en compression (290), **caractérisé en ce que** le procédé comprend au moins les étapes suivantes:
- Fournir une plaque comprenant au moins un premier transistor (100) et un deuxième transistor (200),
- Formation d'au moins une couche contrainte, à base de nitrure, sur le premier transistor (100) et le deuxième transistor (200), la couche contrainte étant contrainte en tension,
- Dépôt d'une couche de protection (400a) de manière à recouvrir une première zone (191) de la couche contrainte, la première zone (191) recouvrant au moins partiellement le premier (100) transistor et à laisser découverte une deuxième zone (291) de la couche contrainte, la deuxième zone (291) recouvrant au moins partiellement le deuxième transistors (200),
- Modification du type de contrainte de la deuxième zone (291) de la couche contrainte, par implantation (500) d'ions à base d'hydrogène à partir d'un plasma dans la deuxième zone (291), de manière à ce que la deuxième zone (291) de la couche contrainte soit contrainte en compression.

2. Procédé selon la revendication précédente dans lequel le dépôt de la couche de protection (400a) est effectué de manière à recouvrir l'intégralité du premier transistor (100), et à laisser entièrement découvert le deuxième transistor (200).

3. Procédé selon l'une quelconque des revendications précédentes dans lequel le premier transistor (100) et le deuxième transistor (200) sont respectivement de type NMOS et PMOS.

4. Procédé selon l'une quelconque des revendications précédentes dans lequel le premier transistor (100) et le deuxième transistor (200) présentent chacun un canal et une couche d'oxyde de grille et dans lequel le premier transistor (100) et le deuxième transistor (200) présentent des caractéristiques différentes prises parmi : une épaisseur de canal différente, une épaisseur d'oxyde de grille différente.

5. Procédé selon l'une quelconque des revendications précédentes dans lequel le plasma est formé à partir d'un mélange comprenant au moins l'un des gaz suivants : H2, HBr, NH3.

6. Procédé selon l'une quelconque des revendications précédentes, dans lequel la couche de protection (400a) comprend du carbone et dans lequel le plasma est formé à partir d'un mélange comprenant au moins un gaz de type CxHy, x et y étant des entiers et de préférence un autre gaz par exemple l'hélium (He) et/ou l'argon (Ar).

7. Procédé selon l'une quelconque des revendications précédentes dans lequel la formation de la couche contrainte est effectuée de manière à ce que la couche contrainte présente une épaisseur comprise entre 2 et 50 nm (10⁻⁹ mètres), de préférence entre 5 et 40nm.

8. Procédé selon l'une quelconque des revendications précédentes dans lequel la formation de la couche contrainte comprend un dépôt conforme et dans lequel le dépôt conforme est effectué par l'un des dépôts suivants : dépôt chimique en phase vapeur assisté par plasma (PECVD), dépôt chimique en phase vapeur assisté à basse pression (LPCVD), dépôt thermique rapide chimique en phase vapeur (RTCVD), dépôt physique en phase vapeur (PVD).

9. Procédé selon l'une quelconque des revendications précédentes dans lequel les paramètres de l'implantation (500), en particulier l'énergie des ions à base d'hydrogène, sont choisis de manière à modifier par implantation toute l'épaisseur de la deuxième zone (291) de la couche contrainte.

10. Procédé selon l'une quelconque des revendications précédentes dans lequel les paramètres de l'implantation (500), en particulier l'énergie des ions à base d'hydrogène, sont choisis de manière à modifier par implantation la deuxième zone (291) de la couche contrainte, de manière continue, depuis la surface de la couche contrainte et jusqu'à une profondeur de l'ordre de 40 nm (10⁻⁹ mètres).

11. Procédé selon l'une quelconque des revendications précédentes dans lequel l'implantation est réalisée à une température ≤ 150°C, de préférence ≤ 130°C et de préférence ≤ 100°C.

12. Procédé selon l'une quelconque des revendications précédentes, dans lequel la première zone (191) recouvre entièrement le premier transistor (100) et la deuxième zone (291) recouvre entièrement le deuxième transistor (200) et dans lequel une tranchée d'isolation électrique (300) sépare le premier transistor (100) et le deuxième transistor (200) et dans lequel une interface définie par la première (191) et la deuxième (291) zones est au moins en partie située au droit de la tranchée d'isolation (300).

13. Procédé selon l'une quelconque des revendications précédentes comprenant une pluralité de séquences, chaque séquence étant appliquée sur lesdits premiers et deuxièmes transistors, chaque séquence comprenant successivement au moins : ladite étape de dépôt d'une couche contrainte, ladite étape de dépôt d'une couche de protection (400a) et ladite étape de modification.

14. Procédé selon la revendication précédente dans lequel à chaque séquence, ladite étape de dépôt d'une couche contrainte est configurée de manière à ce que l'épaisseur de la couche contrainte déposée soit inférieure à 20 nm et de préférence comprise entre 5 nm et 15 nm.

15. Procédé selon l'une quelconque des revendications précédentes dans lequel les premier (100) et deuxième (200) transistors présentent chacun un canal formé dans une couche semi-conductrice, la couche semi-conductrice surmontant une couche diélectrique (120) et un substrat de support (110), et dans lequel la couche semi-conductrice, la couche diélectrique (120) et le substrat de support (110) forment un substrat de type semi-conducteur sur isolant de type FDSOI.
